Europäisches Patentamt

European Patent Office

Office européen des brevets

(11) Publication number: **0 219 243**
**A2**

(12) **EUROPEAN PATENT APPLICATION**

(21) Application number: **86307308.6**

(22) Date of filing: **23.09.86**

(51) Int. Cl.⁴: **H 01 L 21/225**
**H 01 L 29/72**

(30) Priority: **11.10.85 US 786906**

(43) Date of publication of application:
**22.04.87 Bulletin 87/17**

(84) Designated Contracting States:
**DE FR GB NL**

(71) Applicant: **Monolithic Memories, Inc.**
**2175 Mission College Blvd.**
**Santa Clara, CA 95050(US)**

(72) Inventor: **Bhakta, Jayendra**
**5498 Don Rodolfo Court**
**San Jose California 95123(US)**

(72) Inventor: **Patel, Rajiv**
**1656 Peachwood Drive**
**San Jose California 95132(US)**

(74) Representative: **Jones, Ian et al,**
**POLLAK MERCER & TENCH High Holborn House 52-54**
**High Holborn**
**London WC1V 6RY(GB)**

(54) **Process of manufacturing a bipolar transistor.**

(57) A process for forming a buried layer 22 comprises the steps of covering a wafer (10) with a silicon dioxide layer (18). Dopants are introduced into the silicon dioxide layer (18) via an ion implantation process. Thereafter, a second silicon dioxide layer (20) is grown on the first silicon dioxide layer (18) and the wafer (10) is then subjected to a heating process which serves to both anneal the silicon wafer and drive dopants implanted into the first silicon dioxide layer (18) into the silicon wafer. In this way, crystal lattice damage which normally accompanies ion implantation is avoided. The second silicon dioxide layer (20) prevents out diffusion of the implanted ions from the first silicon dioxide layer (18) into the atmosphere. The first and second silicon dioxide layers (18,20) are then removed and an epitaxial layer (24) is formed on the wafer (10). A base region (48) and emitter region (46) are then formed in the epitaxial layer (24).

FIG. 1

EP 0 219 243 A2

Croydon Printing Company Ltd.

-1-

# PROCESS OF MANUFACTURING A BIPOLAR TRANSISTOR

## DESCRIIPTION

This invention relates to the manufacture of a bipolar transistor having a buried layer.

It is known in the art to dope regions in a silicon wafer using ion implantation. While ion implantation is an effective method for providing doped regions, ion implantation processes cause crystal lattice defects in silicon. Such defects can hinder operation of semiconductor devices by causing leakage currents. In addition, crystal lattice defects can degrade layers of silicon dioxide subsequently grown on wafers. Obviously, the higher the dopant concentration used during ion implantation, the greater the defect density produced thereby. Accordingly, there is a trade off that must take place between the amount of resistivity desired and the crystal defect concentration that can be tolerated.

Defects produced by ion implantation can be removed by an annealing process during which silicon is typically heated to a temperature of about 1,000°C for an amount of time dependent on the process involved. Unfortunately, during such processes, dopants can escape from the silicon wafer into the atmosphere. This is known as out diffusion.

It is also known in the art to dope regions in a silicon wafer by forming a mask layer on the wafer, and forming a window region in the mask layer, thereby exposing a portion of the underlying silicon. The mask layer typically includes a silicon dioxide layer covered with a silicon nitride layer. A $Sb_2O_3$ doped silicon dioxide layer is then formed on the wafer using a chemical vapor

0219243

deposition (CVD) process. Antimony is then diffused from the doped silicon dioxide layer into the silicon within the window region.

Unfortunately, it is difficult to control the dopant concentration of the doped regions formed in the silicon with great precision using this technique. Further, when using this technique, small regions are formed in the doped silicon dioxide layer having large $Sb_2O_3$ concentrations. These high dopant concentration regions are known to cause defects in the mask layer, thus causing antimony doped regions in the substrate underneath the mask layer where antimony is not desired.

The invention provides a method for forming a bipolar integrated circuit having a buried layer with a low defect density and a low resistivity. This is accomplished by covering a semiconductor wafer (typically silicon) with a thin silicon dioxide layer. The wafer is then subjected to ion implantation during which the thin silicon dioxide layer absorbs most of the implanted ions and hence most of the implant damage, leaving the semiconductor crystal lattice relatively damage free. A thick silicon dioxide layer is then deposited over the thin silicon dioxide layer in a low temperature deposition process. After that, the wafer is heated, which causes the semiconductor material to become annealed and which also causes the ions previously implanted into the thin silicon dioxide layer to diffuse into the semiconductor material to a desired junction depth. The thick silicon dioxide layer prevents dopants from diffusing into the atmosphere. Because the dopants diffuse through silicon dioxide relatively slowly, and preferentially diffuse into the semiconductor wafer, the loss of dopants into the thick silicon dioxide layer is minimal.

Thereafter, the thin and thick silicon dioxide layers are removed and an epitaxial layer is deposited on the wafer. Isolation regions are then formed in the epitaxial layer to electrically isolate an area in the epitaxial layer where a bipolar transistor is to be formed. Base and emitter regions are then formed, e.g. by ion implantation. In this way, a transistor is provided having a buried layer with a low defect density and low resistivity.

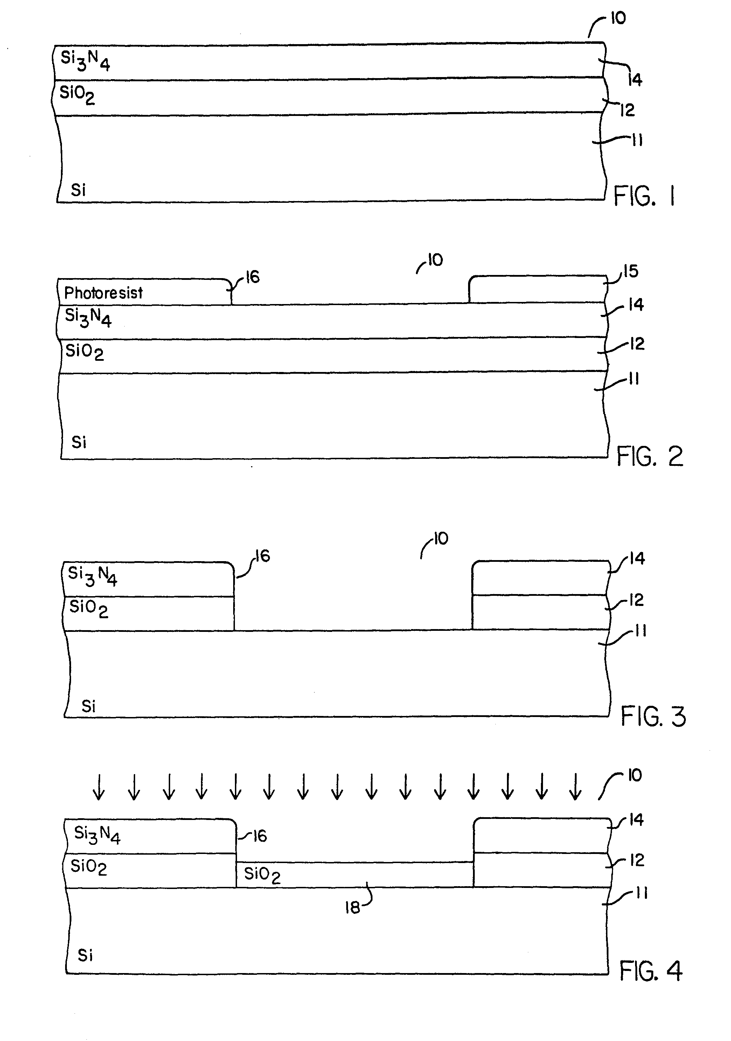

The invention is further explained below, by way of example, with reference to the accompanying drawings, in which Figures 1 to 13 are cross sectional illustrations of successive stages of a process of manufacturing a bipolar transistor in accordance with the present invention.

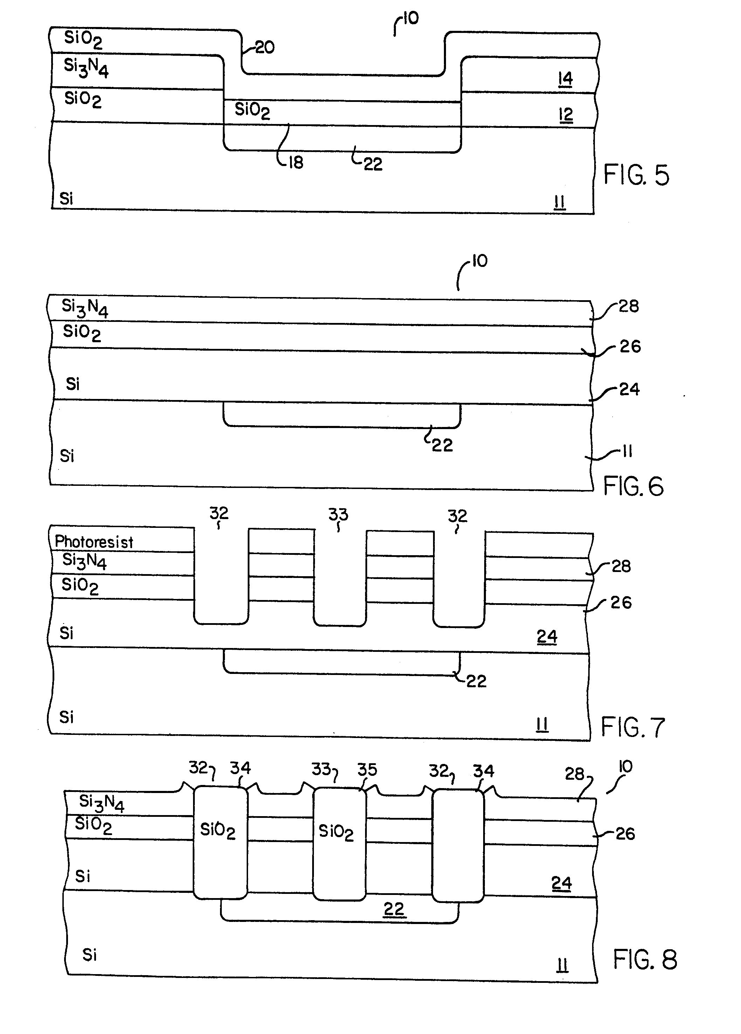

The illustrated process for manufacturing a bipolar transistor in accordance with the present invention begins with the step of forming a silicon dioxide layer 12 on a semiconductor wafer 10 (Figure 1). In one embodiment of the invention, semiconductor wafer 10 has a silicon substrate 11 having a [100] crystal orientation, a P type conductivity, and a resistivity of 25 to 45 ohm-centimeters. However, other semiconductor materials having either P or N type conductivity and having other resistivities can also be used. In one embodiment of the invention, silicon dioxide layer 12 is about 1,000 Å thick and is formed by heating wafer 10 to a temperature of about 1100°C in an oxygen atmosphere for approximately 3.5 hours. A silicon nitride layer 14 is then formed on wafer 10. In one embodiment, silicon nitride layer 14 is about 1500Å thick and is formed by a chemical vapor deposition (CVD) process. As described below, silicon nitride layer 14 serves as a mask during the formation of buried layer 22 (Figure 5). Silicon dioxide layer 12 serves as an intermediate layer which prevents mechanical stress caused by the difference in thermal expansion of silicon substrate 11 and silicon nitride layer 14.

Referring to Figure 2, wafer 10 is covered with a
photoresist layer 15, which is selectively exposed to
light and developed, thereby forming a window region 16 and exposing a portion of silicon nitride layer 14. Window 16 defines the area where buried layer 22 will subsequently be formed.

The portion of silicon nitride layer 14 and silicon dioxide layer 12 under window 16 is then removed using conventional etching techniques, and remaining photoresist 15 is removed, leaving the structure of Figure 3. In one embodiment, the exposed portion of silicon nitride 14 is removed in a plasma etching process and the portion of silicon dioxide 12 lying thereunder is removed with hydroflouric acid.

Referring to Figure 4, a silicon dioxide layer 18 is formed in window 16. In one embodiment, silicon dioxide layer 18 is about 250A thick and is formed by heating wafer 10 to about 950°C in an oxygen atmosphere for approximately 40 minutes. In accordance with one novel feature of this invention, wafer 10 is then subjected to an ion implantation process. Typically antimony ions are implanted into silicon dioxide layer 18 with an energy of about 50 KEV and a dosage of about $3 \times 10^{15}$ ions/cm$^2$. However, other ions, implant energy, and dosages could also be used. During this process, it has been estimated that 85% of the antimony ions reaching window region 16 are implanted into silicon dioxide layer 12 with the remaining 15% implanted into silicon substrate 11. Because of this, damage to the crystal lattice of substrate 11 is less than the damage which would occur if the ions were all implanted into substrate 11.

Ions implanted into silicon dioxide layer 18 are subsequently diffused into silicon substrate 11 to form a buried layer as described below. Of importance, ions striking wafer 10 outside of window region 16 lodge in either silicon nitride layer 14 or silicon dioxide layer 12. Because of the thickness of layers 12 and 14, during this subsequent diffusion step, ions do not diffuse from layers 12 and 14 into substrate 11. In this way, layers 12 and 14 confine the formation of the buried layer to the area defined by window 16.

Referring to Figure 5, a layer of material such as silicon dioxide layer 20 is then formed on wafer 10. In one embodiment, silicon dioxide layer 20 is about 3,000Å thick and is deposited via a CVD process. Of importance, this is done at a low temperature, e.g., 425°C, so that implanted dopants do not diffuse out of silicon dioxide layer 18 into the atmosphere. Thereafter, wafer 10 is subjected to a combination annealing/drive-in diffusion process. Specifically, wafer 10 is baked at about 1250°C for about 17 minutes in an inert gas, e.g. nitrogen or argon. During this process, antimony ions diffuse out of silicon dioxide layer 18 and into silicon substrate 11 thus forming N type region 22 (the buried layer). Buried layer 22 is thus formed to a thickness of about 3μ, but if a thicker buried layer is desired, a longer baking time is used. It is noted that by limiting the baking time, lateral diffusion of buried layer 22 is minimized. Silicon dioxide layer 20 prevents out diffusion of antimony into the atmosphere during this process. Because the implanted dopants diffuse through silicon dioxide slowly, the loss of dopants diffused into silicon dioxide layer 20 is minimal. Table I below indicates the junction depth between the antimony doped region 22 of substrate 11 and the P doped portion of substrate 11 for baking times of 18 minutes and 74 minutes for various conditions. (The data of Table I is from a computer simulation.) As can be seen in Table I, the sheet resistance of the buried layer is lower when using silicon dioxide layer 20 than when not using layer 20.

TABLE I*

0219243

| Layer 18 | Layer 20 | Anneal Time** | Junction Depth | Buried Layer Sheet Resistance |
|---|---|---|---|---|
| not present | not present | 18 min. | 3μ | 24 Ω/square |
| not present | 3,000A | 18 min. | 3μ | 20 Ω/square |
| 250A | not present | 18 min. | 3μ | 23 Ω/square |
| 250A | 3,000A | 18 min. | 3μ | 19 Ω/square |
| 300A | 3,000A | 74 min. | 5μ | 20 Ω/square |
| 300A | not present | 74 min. | 5μ | 27 Ω/square |

*Drive in temperature is 1,250°C

**Includes a ramp-up time of 50 minutes while temperature increases from 750°C to 1,250°C at a rate of 10°C/minutes and a ramp-down time of 120 minutes while the temperature falls from 1,250°C to 830°C.

Thereafter, silicon dioxide layers 12, 18 and 20 and silicon nitride layer 14 are removed, leaving N type region 22 doped with antimony in P type substrate 11.

An epitaxial layer is then formed on wafer 10, and a bipolar transistor is formed in the epitaxial layer. In one process for forming the bipolar transistor, an N type epitaxial layer 24 (Figure 6) is then formed on wafer 10. In one embodiment, epitaxial layer is approximately 2 microns thick and is deposited by a CVD process. Epitaxial layer 24 typically has a conductivity of about 0.5 ohm-centimeters. A silicon dioxide layer 26 and a silicon nitride layer 28 are then formed on wafer 10. In one embodiment of the invention, silicon dioxide layer 26 is thermally grown to a thickness of about 1,000A by heating wafer 10 to a temperature of about 950°C in an oxygen atmosphere for approximately 1/3 hours. Silicon nitride layer 28 is typically 1500A thick and is deposited by a CVD process.

Wafer 10 then is coated with a photoresist layer 30 (Figure 7), and selectively exposed to light. The exposed portions of photoresist layer 30 are then removed, leaving windows 32 and 33. (Although drawn as two windows, window 32 is really a single window surrounding buried layer 22.) Window 32 defines the area where an isolation region is to be formed in wafer 10. Window 33 defines where a second silicon dioxide region is to be formed which prevents a highly doped collector contact region from forming a capacitive PN junction with the to-be-formed transistor base region. The portion of silicon dioxide layer 26 and silicon nitride layer 28 underneath windows 32 and 33 is removed via a conventional plasma etching process using, for example, $CF_4$ as the process gas. In addition, an 8000 to 9000A thick portion of epitaxial layer 24 under windows 32 and 33 is also removed via a plasma etching process using, for example, $SF_6$ as the process gas. The remaining portion of photoresist layer 30 is then removed, and isolation regions 34 and 35 are formed in windows 32 and 33, respectively (Figure 8). In one embodiment, isolation regions 34 and 35 are silicon dioxide between 1.8 and 2 microns thick and are grown by heating wafer 10 to a temperature of 920°C for 2½ to 3 hours in steam at high pressure (about 15 atmospheres). Of importance, approximately 55% of isolation regions 34 and 35 grow into epitaxial layer 24 while the remainder grows into window 32. Thus, the top of isolation region 34 is roughly coplanar with the top of epitaxial layer 24.

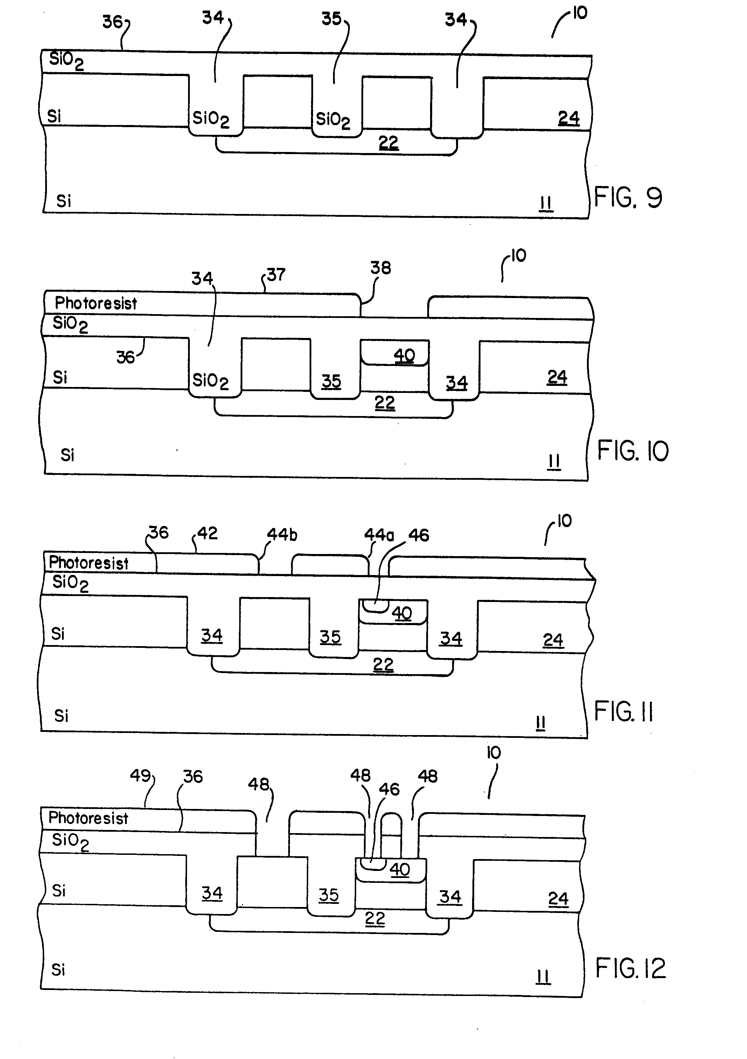

Referring to Figure 9, silicon nitride region 28 is removed (typically with phosphoric acid) and silicon dioxide layer 26 is removed (typically with hydroflouric acid). During removal of silicon dioxide layer 26, small amounts of silicon dioxide from regions 34 and 35 are also removed. However, these amounts represent a negligible portion of regions 34 and 35.

Referring to Figure 9, a silicon dioxide layer 36 (typically about 2900A thick) is grown on wafer 10. In one embodiment, this is done by heating the wafer to a temperature of about 1050°C in steam for about 20 to 25 minutes.

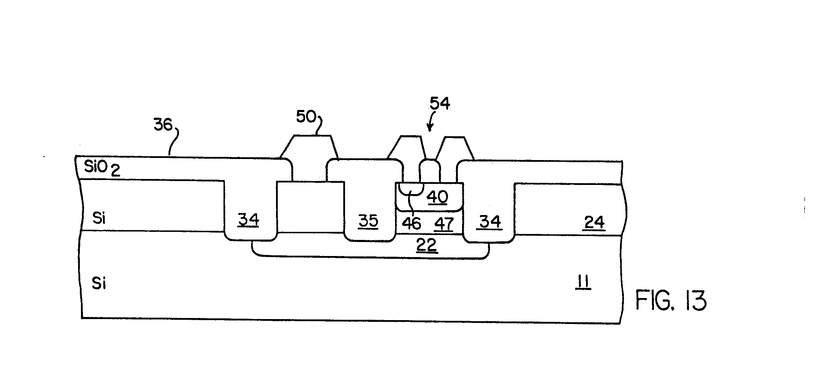

Referring to Figure 10, wafer 10 is then coated with a photoresist layer 37. Photoresist layer 37 is then patterned leaving a window 38 which defines the base region of the to-be-formed bipolar transistor. In one embodiment, the exposed portion of wafer 10 is then subjected to an ion implantation process which results in the formation of a P type base region 40. In one embodiment, boron ions are used, with an implant energy of about 150 KEV and a dosage between about $4 \times 13^{13}$ and $8 \times 10^{13}$ ions/cm$^2$. Photoresist layer 37 is then removed. Referring to Figure 11, wafer 10 is then coated with another photoresist layer 42 which is selectively patterned leaving windows 44a and 44b. Window 44a defines an emitter region 46 which in one embodiment is formed during an ion implantation process using, for example, arsenic ions, an implant energy of approximately 50 KEV, and a dosage between $1 \times 10^{16}$ and $3 \times 10^{16}$ ions/cm$^2$. The portion of epitaxial layer 24 within window 44b is also implanted with ions during this process, thus facilitating formation of a collector contact for the transistor. Photoresist layer 42 is then removed.

Openings 48 (Figure 12) are then etched in silicon dioxide layer 36, e.g. by coating wafer 10 with a photoresist layer 49, and selectively exposing photoresist layer 49 and removing the exposed portions, thereby exposing portions of silicon dioxide layer 36. The exposed portions of silicon dioxide layer 36 are then removed using, for example, a buffered HF solution, leaving openings 48. Photoresist layer 49 is then removed.

Referring to Figure 13, a conductive layer 50 (such as metal or polycrystalline silicon) is then formed on wafer 10 and patterned, e.g. by covering the wafer with photoresist

0219243

(not shown), patterning the photoresist, thereby exposing portions of conductive layer 50, and removing the exposed portions. The photoresist is then removed, leaving a bipolar transistor 54 in which conductive layer 50 makes electrical contact with base 40, emitter 46, and collector 47. Low resistance buried layer 22 isolates transistor 54 from substrate 11. In addition, collector 47 is connected to the collector contact via buried layer 22.

While the invention has been described with reference to a specific embodiment, those skilled in the art will recognize that modifications can be made to form and detail without departing from the scope of the invention. For example, layers 12 and 14 can be formed from substances other than silicon dioxide and silicon nitride, and can have thicknesses other than those described. In addition, ions other than antimony can be used and a wafer having a crystal orientation other than a [100] orientation can be used. In addition, the starting material can be either P type or N type. Accordingly, all such changes come within the present invention.

CLAIMS

1. A process of manufacturing a bipolar transistor having a buried layer (22) comprising the steps of forming a doped region in semiconductor material (11), forming an epitaxial layer (24) over the doped region, and forming a bipolar transistor in the epitaxial layer, the doped region serving as a buried layer (22), characterized by the steps of:

forming a layer (18) of a first material over the semiconductor material prior to the step of forming the epitaxial layer;

implanting ions into the layer (18) of first material; and

diffusing the ions out of the layer (18) of the first material and into the semiconductor material (11), thereby forming the doped region (22).

2. A process as claimed in claim 1 wherein the semiconductor material is silicon.

3. A process as claimed in claim 1 or 2 comprising the further step of forming a layer (20) of a second material over the layer of the first material, the layer (20) of the second material preventing out diffusion of ions into the atmosphere during the step of diffusing the ions.

4. A process as claimed in claim 3 wherein the first and second materials are silicon dioxide.

5. A process as claimed in claim 4 wherein the layer (20) of the second material is formed by a chemical vapor deposition process.

6. A process as claimed in claim 5 wherein the layer (20) of the second material is deposited at a temperature less than 700°C.

7. A process as claimed in any preceding claim comprising the further steps of:

forming a layer (12,14) of a third material on the wafer before forming the layer of the first material;  and

etching a window region (16) in the layer (12,14) of the third material, the layer (18) of the first material being formed in the window region, the layer (12,14) of the third material being thicker than the layer (18) of the first material, ions being implanted into the layer (12,14) of the third material during the step of implanting ions, but not diffusing from the layer (12,14) of third material into the semiconductor material (11) during the step of diffusing the ions.

8.    A process as claimed in claim 7 wherein the third material comprises silicon dioxide.

9.    A process as claimed in claim 7 or 8 wherein the third material comprises silicon nitride.

10.    A process as claimed in claim 7, 8 or 9 wherein the layer (12,14) of the third material is removed prior to the formation of the epitaxial layer (24).

0219243

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13